# EUROPEAN PATENT APPLICATION

(11) **EP 4 307 393 A1**
(43) Date of publication of application: **17.01.2024**
(21) Application number: 22184356.8
(22) Date of filing: 12.07.2022
(51) Int. Cl.: H01L 31/02, H02S 40/34

(54) **METHOD FOR MANUFACTURING A SOLAR CELL MODULE AND SOLAR CELL MODULE**

(71) Applicant: Meyer Burger (Switzerland) AG, 3645 Gwatt/Thun (CH)
(72) Inventor: RATH, Christian, 3604 Thun (CH)
(74) Representative: Kraus & Weisert Patentanwälte PartGmbB

(57) **Abstract**

Examples disclose a method for manufacturing a solar cell module (1800), wherein the method comprises arranging a solar cell, a connecting wire (1431) having a contacting portion electrically contacting a solar cell contact of the solar cell, and a collecting portion of an interconnector crossing the connecting wire (1431) and electrically contacting the connecting wire (1431) between a front side encapsulation layer (1471) and a back side encapsulation layer (1472), laminating to obtain a solar cell module laminate comprising the front side encapsulation layer (1471), the solar cell, and the back side encapsulation layer (1472), providing a junction box (1880) on the solar cell module laminate such that the back side encapsulation layer (1772) is arranged between the front side encapsulation layer (1771) and the junction box (1880), wherein the junction box (1880) comprises a housing and a conductor (1881), and contactless materially bonding the conductor (1881) to an end portion (17411) of the interconnector.Further examples disclose a solar cell module (1800).

## Description

The disclosure relates to a solar cell module and a method for manufacturing a solar cell module. A solar cell module may also be called a photovoltaic module.

WO 2015/001413 A1 discloses a solar cell module, sometimes also called photovoltaic module, comprising several solar cell strings, wherein each solar cell string comprises several solar cells connected in series. The solar cells are arranged between a front-side encapsulation layer and a back-side encapsulation layer.

Further, WO 2011/011855 A1 proposes a method for connecting several rear contact solar cells, in particular interdigitated back contact (IBC) solar cells. In particular, solar cell strings may be formed by electrically connecting several solar cells in series using a plurality of parallel connecting wires.

According to WO 2019/191689 A1, solar cells may have wire metallization thereon stringing the solar cells. Busbars and/or interconnectors are included at the ends of the wire metallization. The busbars or interconnectors are folded over a footprint of the solar cells. An insulator feature can be included to isolate the folded portion of the wire metallization from another wire metallization on the solar cells. Said wire-based metallization may enable fabrication of busbars or interconnectors that are folded in behind cells to reduce overall solar cell module size and thus increase solar cell module efficiency.

Solar cell modules have to be connectable to electrical installations. Heretofore, electrical cables have to be connected to the solar cell modules. Sometimes, the solar cell modules also include bypass diodes. Typically, the terminals for connecting the electrical cables and the bypass diodes are accommodated in one or more junction boxes provided at a back side of the solar cell module. The conductors provided in the junction boxes have to be electrically connected to the busbars and/or interconnectors, preferably after the lamination process, in which the solar cells have been encapsulated between a front glass and a back glass or back sheet.

There may be a need for facilitating said connection.

Said need has been addressed with the subject-matter of the independent claims. Advantageous embodiments are described in the dependent claims.

According to a first aspect, examples disclose a method for manufacturing a solar cell module, wherein the method comprises arranging a solar cell, a connecting wire having a contacting portion electrically contacting a solar cell contact of the solar cell, and a collecting portion of an interconnector crossing the connecting wire and electrically contacting the connecting wire between a front side encapsulation layer and a back side encapsulation layer, wherein an end portion of the interconnector is passed through an opening of the back side encapsulation layer, laminating to obtain a solar cell module laminate comprising the front side encapsulation layer, the solar cell, and the back side encapsulation layer, providing a junction box on the solar cell module laminate such that the back side encapsulation layer is arranged between the front side encapsulation layer and the junction box, wherein the junction box comprises a housing and a conductor, and contactless materially bonding the conductor to the end portion of the interconnector.

According to some examples, solar cell contacts having a first polarity may be provided on a different side of the solar cell than solar cell contacts having a second polarity. Other examples may prescribe that the solar cell contacts having the first polarity and the solar cell contacts having the second polarity are provided on the same side of the solar cell. The solar cell may comprise an IBC solar cell.

In examples, the connecting wires may have an approximately circular crosssection. In other examples, the connecting wires may have an elongated crosssection. The connecting wires may correspond to ribbons typically used for contacting solar cell contacts. Each solar cell may include its own plurality of connecting wires. In some examples, the connecting wires may correspond to wires used within a SmartWire Connection Technology (SWCT^{™}) connecting technology described in DE 10 2020 109600 A1 for example. At least two solar cells may share a plurality of connecting wires. The plurality of connecting wires may be used for electrically connecting the solar cells in series or in parallel.

In some example, the conductor is partly encapsulated in the housing.

Further examples may prescribe that the conductor is enclosed by the housing and the solar cell module laminate after arranging the junction box on the solar cell module laminate.

The junction box may be glued and/or taped to the solar cell module. In particular, the junction box may be glued and/or taped to the solar cell module laminate before bonding the conductor to the end portion of the interconnector. This may facilitate keeping the position of the junction box with respect to the solar cell module laminate fixed during bonding the conductor to the end portion of the interconnector.

Contactless materially bonding may comprise at least one of induction soldering, induction welding, and laser welding. The electro-magnetic energy required for these processes may be applied through the housing of the junction box. For example, the housing of the junction box may be transparent for the wavelength used for laser welding such that the laser beam is only absorbed by the conductor and/or end portion of the interconnector to establish the bond.

The conductor may be elastic. Due to the elasticity the conductor may be pressed against the end portion of the interconnector when the junction box is arranged at the back side of the solar cell module laminate and establish a mechanical contact which allows for materially bonding the conductor to the end portion.

The housing of the junction box may be lid free. Thus, all elements, e.g. bridging elements, cables, conductors, may be (at least partially) encapsulated by the housing.

In some examples, the method may include backfolding the end portion of the interconnector. Further examples may prescribe passing the end portion through a through hole of a back glass and/or back sheet of the solar cell module before folding back the end portion of the interconnector.

The method may further comprise arranging a back sheet and/or back glass on a side of the interconnector opposite of the first solar cell such that a slot of the back sheet and/or back glass accommodates the backfolded portion.

Examples propose laminating the solar cell module after folding back the end portion of the interconnector.

The method may include covering a side of the end portion opposite to the solar cell, in particular with an adhesive film, before laminating the solar cell module.

Examples of the method further comprise removing insulating material on a side of the backfolded portion opposite to the collecting portion before bonding.

According to a second aspect, examples disclose a solar cell module comprising a solar cell module laminate including a solar cell, a connecting wire having a contacting portion electrically contacting a solar cell contact of the solar cell, and a collecting portion of an interconnector crossing the connecting wire and electrically contacting the connecting wire, wherein the solar cell, the connecting wire and the collecting portion are arranged between a front side encapsulation layer and a back side encapsulation layer, wherein an end portion of the interconnector passes through an opening of the back side encapsulation layer; a junction box on the solar cell module laminate, wherein the back side encapsulation layer is arranged between the front side encapsulation layer and the junction box, wherein the junction box comprises a housing and a conductor, wherein the conductor is materially bonded to the end portion of the interconnector.

A contacting interface between the conductor and the end portion may be arranged in a plane parallel to the solar cell. A specific plane parallel to a reference plane may correspond to a specific plane arranged at a distance to the reference plane and/or a specific plane arranged within the reference plane.

In examples, the conductor is materially bonded to the end portion. The conductor may be soldered to the end portion. The conductor may also be welded, in particular electrical resistance welded or laser welded, to the end portion.

In examples, the end portion may be a backfolded portion. This may lead to a more esthetical appearance from a front side of the solar cell module as will be explained further below.

The collecting portion of the interconnector may be arranged between the backfolded portion and the first solar cell.

In examples of the solar cell module, the interconnector may pass through a through hole of a back glass and/or back sheet of the solar cell module, wherein the back glass and/or back sheet is arranged between the collecting portion and the backfolded portion of the interconnector.

The end portion may also be accommodated in a slot of a back sheet and/or a back glass of the solar cell module.

Some examples may prescribe that the conductor is bonded to an end portion of the interconnector opposite to the solar cell.

The conductor may be connected to a bridging element, in particular to a diode and/or semiconductor switch and/or a transistor. Alternatively or in addition, the conductor may be connected to a terminal, wherein the terminal is configured for connecting the solar cell module to an electrical cable.

Examples of the proposed solar cell module are described with respect to the drawing in which:
Fig. 1 shows a solar cell module;
Fig. 2 shows a solar cell string;
Fig. 3 shows a portion of a solar cell unit;
Fig. 4 shows a portion of a solar cell module;
Fig. 5 shows a portion of a solar cell module;
Fig. 6 illustrates a partly manufactured solar cell module;
Fig. 7 illustrates a partly manufactured solar cell module;
Fig. 8 illustrates a partly manufactured solar cell module;
Fig. 9 illustrates a partly manufactured solar cell module;
Fig. 10 illustrates a partly manufactured solar cell module;
Fig. 11 illustrates a partly manufactured solar cell module;
Fig. 12 illustrates a partly manufactured solar cell module;
Fig. 13 illustrates a partly manufactured solar cell module;
Fig. 14 illustrates a partly manufactured solar cell module;
Fig. 15 illustrates a partly manufactured solar cell module;
Fig. 16 illustrates a party manufactured solar cell module;
Fig. 17 illustrates a partly manufactured solar cell module;
Fig. 18 illustrates a partly manufactured solar cell module;
Fig. 19 illustrates a partly manufactured solar cell module;
Fig. 20 shows a solar cell module;
Fig. 21 shows a solar cell string;
Fig. 22 illustrates a partly manufactured solar cell module; and
Fig. 23 illustrates a partly manufactured solar cell module.

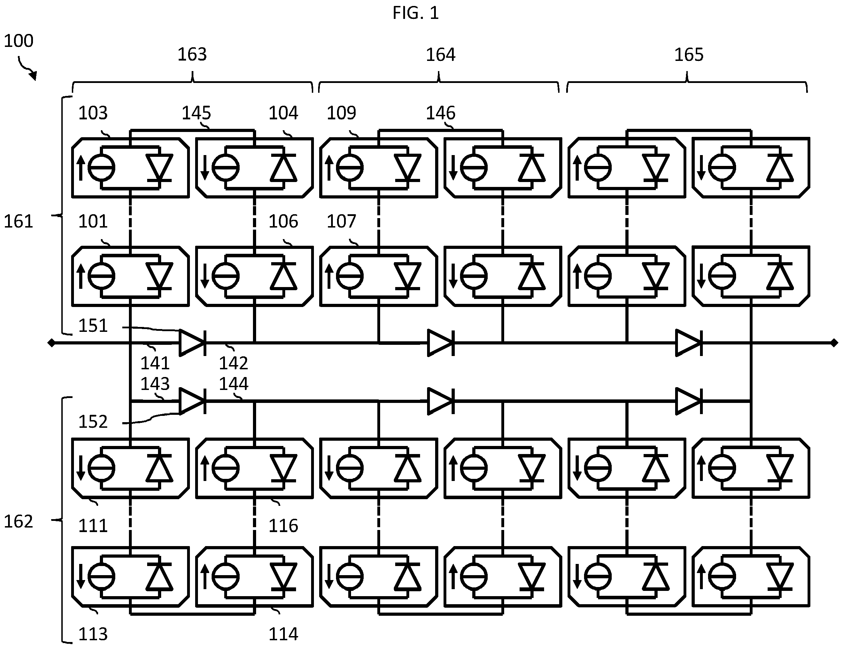

Fig. 1 shows a solar cell module 100. In particular, Fig. 1 schematically illustrates the electrical circuit of the solar cell module 100 and the arrangement of the solar cells 101, ..., 116, etc. of the solar cell module 100, when looking on a front side of the solar cell module 100.

The solar cell module 100 comprises a first solar cell unit 161 and a corresponding second solar cell unit 162. The first solar cell unit 161 and the second solar cell unit 162 are electrically connected in parallel. The first solar cell unit 161 comprises three similar solar cell subunits 163, 164, 165 connected in series. Generally, the first solar cell unit 161 may also comprise fewer or more subunits connected in series.

The first solar cell subunit comprises a first solar cell string including the solar cells 101, ..., 103 and a second solar cell string including the solar cells 104, ... 106. Each solar cell string may comprise two or more solar cells.

The first solar cell string may be electrically connected in series with the second solar cell string using an interconnector 145. In particular, the first solar cell string and the second solar cell string may share the same interconnector 145. A first bridging element 151 is electrically connected in parallel to the solar cell subunit 163. Similarly, a second bridging element 152 is electrically connected in parallel to a solar cell subunit of the second solar cell unit 162. Further bridging elements may be provided for the further solar cell subunits 164, 165, ... of the solar cell unit 161 und the solar cell subunits of the solar cell unit 162. The bridging elements shown in Fig. 1 are diodes 151, 152. The diodes 151, 152 may also be called bypass diodes. However, different bridging elements, e.g. active switches, may be used alternatively or in addition. The bridging element 151 may allow for current to pass through the solar cell unit 161 in case the solar cells 101, ..., 103, 104, ..., 106 of the solar cell subunit 163 are not irradiated. This may increase the efficiency of the solar cell module 100.

The bridging element 151 is electrically connected to interconnectors 141, 142 of solar cells 101,106 and bridging element 152 is electrically connected to interconnectors 143, 144 of solar cells 111, 116. Providing separate bridging elements for the solar cell subunits 163, 164, 165 of the solar cell unit 161 and the solar sell subunits of the solar cell unit 162 may increase the efficiency of the solar cell module 100 compared to known solar cell modules, in which two solar cell subunits electrically connected in parallel share one or more common bridging elements.

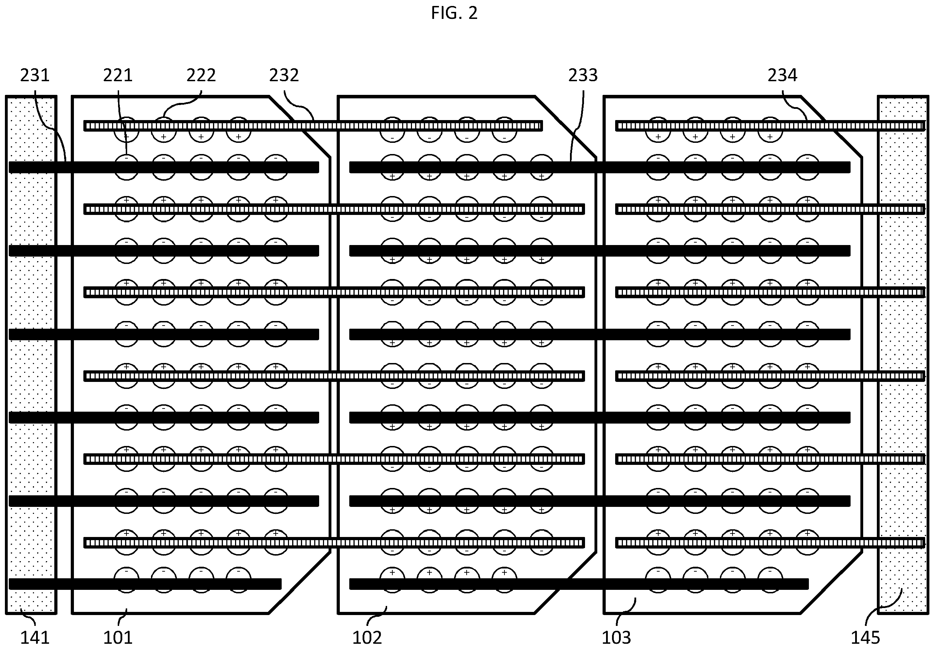

Fig. 2 further illustrates the first solar cell string comprising the solar cells 101, 102, 103. The solar cell string is shown from the back side of the solar cell module 100. The solar cells 101, 102, 103 include solar cell contacts 221 having a first polarity, e.g. minus or plus, and solar cell contacts 222 having a second polarity, e.g. plus or minus, respectively.

The solar cell string comprises a first plurality of parallel connecting wires 231 having a contacting portion electrically contacting the solar cell contacts 221 having the first polarity of the solar cell 101 and a second plurality of parallel connecting wires 232 electrically contacting the solar cell contacts 222 having the second polarity of the solar cell 101.

An interconnector 141 is provided having a collecting portion crossing the first plurality of parallel connecting wires 231 and electrically contacting the first plurality of parallel connecting wires 231.

The second plurality of parallel connecting wires 232 electrically contacts solar cell contacts of the solar cell 102 having the first polarity. Thus, the second plurality of parallel connecting wires 232 electrically connects the solar cell 101 and the solar cell 102 in series. Similarly, further pluralities of parallel connecting wires 233, 234 connect the solar cell 102 and the solar cell 103 in series and connect the solar cell 103 to the interconnector 145.

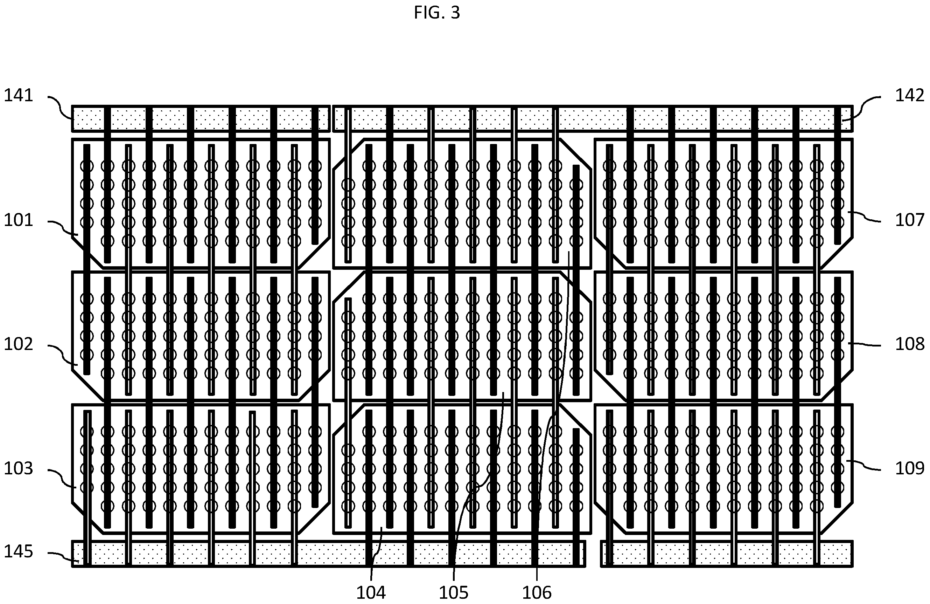

Fig. 3 shows a portion of the solar cell unit 161. The portion of the solar cell unit 161 is shown from the back side of the solar cell module 100. Fig. 3 illustrates three solar cell strings consisting of solar cells 101, 102, 103, solar cells 104, 105, 106 and solar cells 107, 108, 109, respectively. The solar cell strings are connected in series. Heretofore, the solar cells 103, 104 share the common interconnector 145 and the solar cells 106, 107 share the common interconnector 142.

As illustrated in Figs. 1 to 3, the interconnectors 141, 142, 143, 144, 145, 146, ... may be provided laterally of the solar cells. Thus, a substantial portion of the front surface of the solar cell module 100 may be occupied by the interconnectors and cannot be used for collecting radiation.

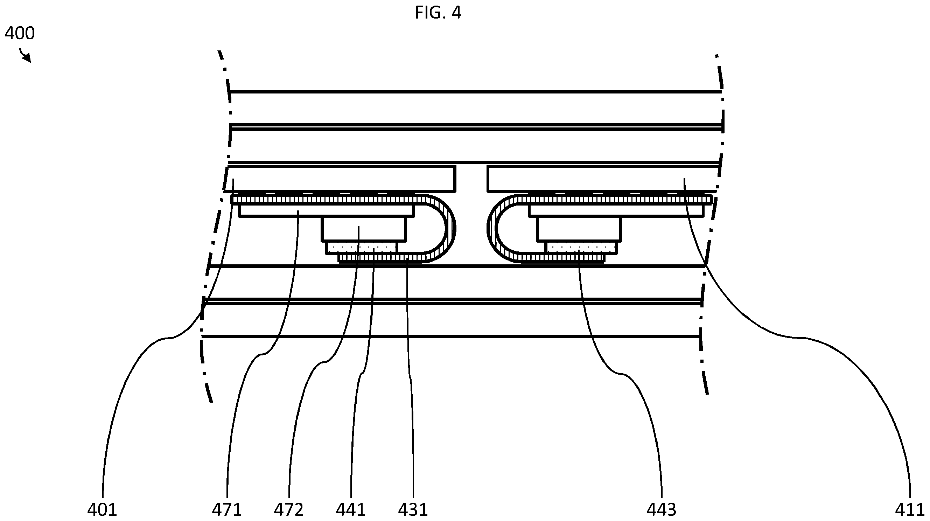

As shown in Fig. 4, the connecting wires 431 may be bent and the interconnectors 441, 443 may be provided at the back side of the solar cell module 400. Thus, the solar cells 401, 411, which may correspond to the solar cells 101, 111 shown in Fig. 1, may be arranged closer together. Typically, the connecting wires 431 are arranged on foil segments 471 before they are soldered to the contacts of the solar cells 401, 411. As shown in Fig. 4, a buffer strip 472 may be provided between the foil segment 471 and the interconnector 441. The interconnector 441 is provided between the bent portions of the connecting wires 431 and the buffer strip 472.

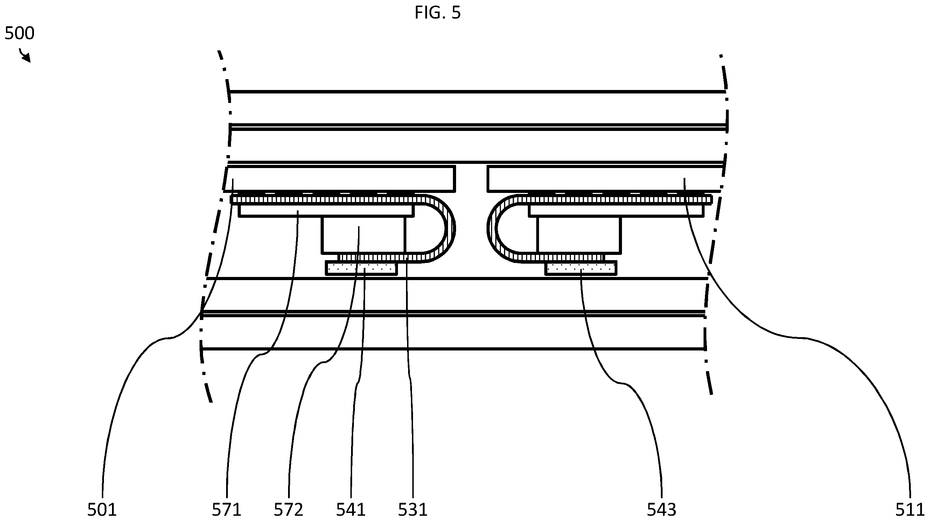

Fig. 5 shows a portion of a solar cell module 500 similar to the solar cell module 400. The elements 501, 571, 572, 541, 531, 543, 511 correspond to elements 401, 471, 472, 441, 431, 443, 411 shown in Fig. 4. In contrast to the solar cell module 400, the bended portions of the connecting wires 531 are provided between the interconnector 541 and the buffer strip 572.

The solar cells of solar cell modules and their connections have to be protected from the environment to avoid degradation and damage. Typically, they are encapsulated in a laminate. However, some electrical connectors have to be passed through the laminate to allow for connecting the solar cell module to a cable. In some cases, the bridging elements are to be provided outside of the laminate, too. Said connections are often provided in a junction box provided on a back side of the solar cell module.

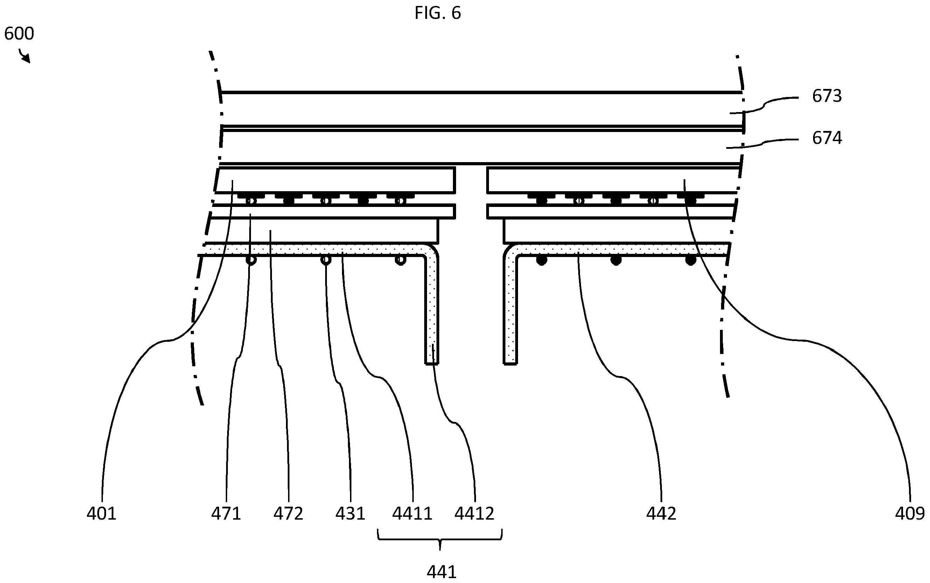

Fig. 6 illustrates a partly manufactured solar cell module 600 corresponding to the solar cell module 400 shown in Fig. 4. On a front side of the solar cells 401, 409 a front side encapsulation layer 674 and a front glass 673 are provided. A front glass may also comprise any transparent material, e.g. a transparent plastic. The connecting wires 431 have been connected to the interconnector 441. Likewise, connecting wires connect the solar cell 409 to the interconnector 442. The interconnector 441 comprises a collecting portion 4411 collecting the current from the plurality of parallel connecting wires 431 and an end portion 4412. The end portion 4412 is angled with respect to the collecting portion 4411. The angle may correspond to approximately 90 degree. The end portion 4412 may be bent before the interconnector 441 is connected to the connecting wires 431.

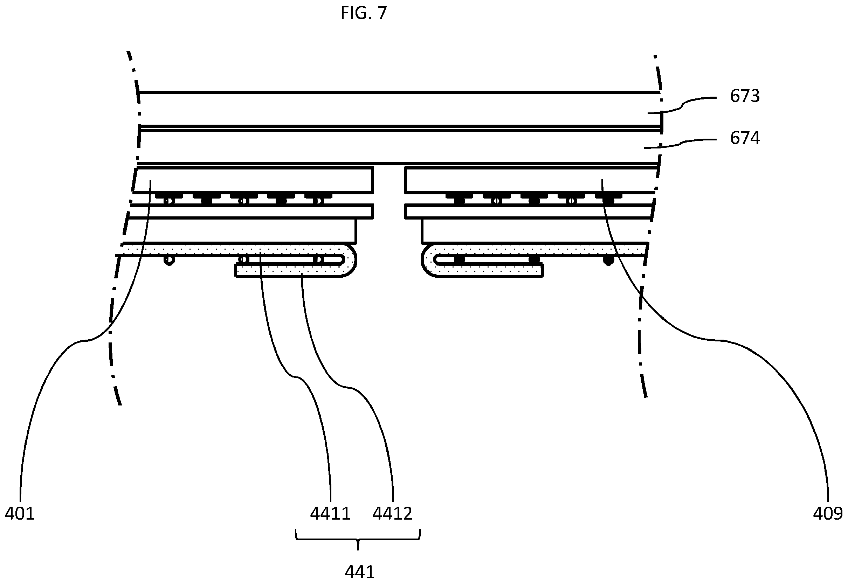

As shown in Fig. 7, the end portion 4412 may be folded back such that the end portion 4412 is arranged parallel to the collecting portion 4411. In such a case, the end portion 4412 may also be called backfolded portion.

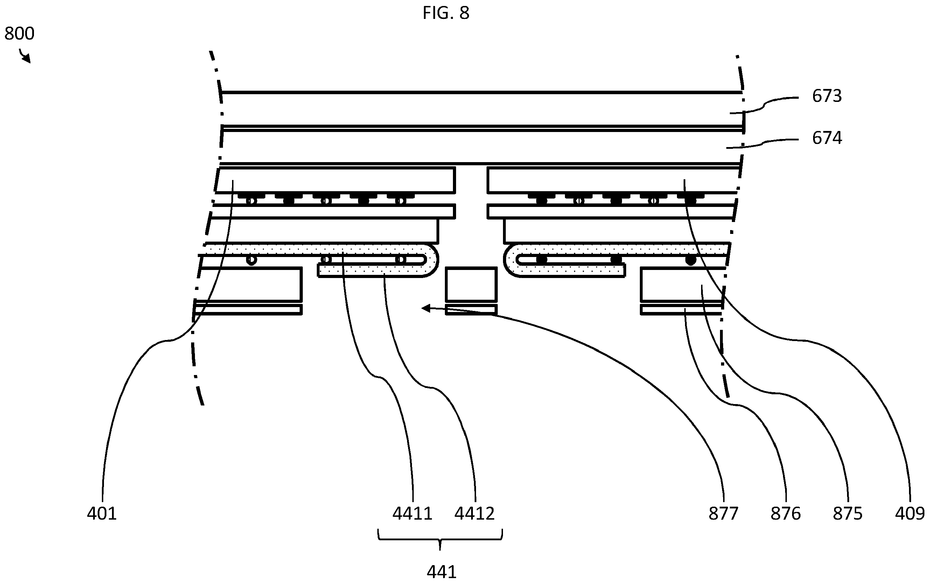

According to Fig. 8, a back side encapsulation layer 875 and a back sheet 876 may be provided on a back side of the partially manufactured solar cell module 800. Slots like the slot 877 are provided in the back side encapsulation layer 875 and the back sheet 876. The backfolded portion 4412 of the interconnector 441 is accommodated in the slot 877. Afterwards heat as well as pressure from the front side and the back side may be applied. This may cause the encapsulation material to become soft or melt such that it may flow in the cavities of the stack. This process may also be called lamination and may be performed in a laminator (not shown). Due to the backfolded portion 4412 being accommodated in the slot 877, the front side and back side of the party manufactured solar cell module 800 may be essentially flat which facilitates laminating.

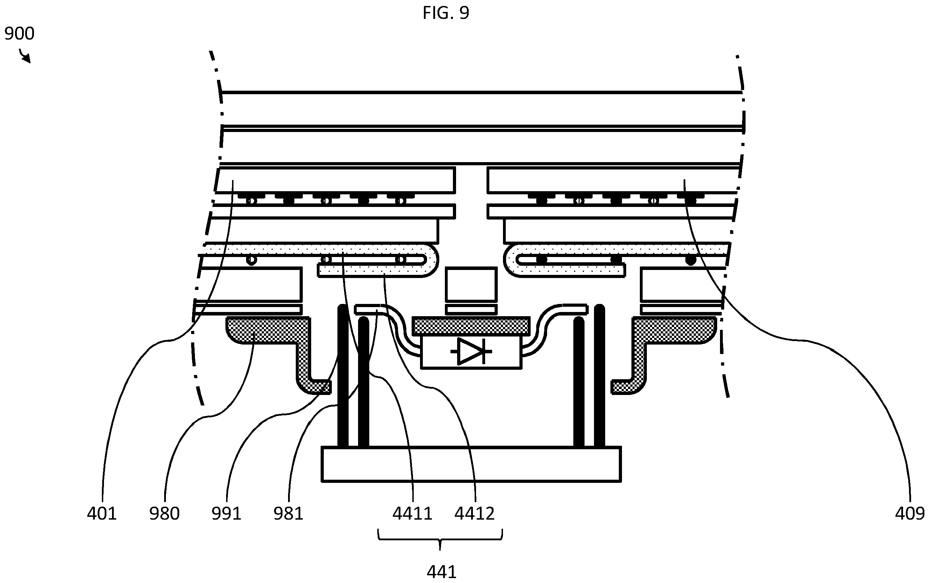

As shown in Fig. 9, a junction box 980 may be attached to a back side of the laminated, partly manufactured solar cell module 900. The junction box 980 comprises a conductor 981. The conductor 981 may be part of a bridging element of the solar cell module 900, in particular, part of a bypass diode. The conductor 981 is electrically connected and, in examples advantageously materially bonded (German: stoffschlüssig verbunden), to the interconnector 441. The contacting/bonding interface between the conductor 981 and the end portion 4412 of the interconnector 441 is essentially provided in a plane parallel to the solar cells 401 between the conductor 981 and the solar cell 401.

The arrangement of the bonding interface facilitates the bonding process. In particular, the location of the bonding may be easily reachable for bonding machines, e.g. a welding apparatus or a soldering apparatus. For example, a single translational movement of the bonding machine in one direction (i.e., from bottom to top) may be sufficient for the bonding process.

The method also avoids bending the interconnector 441 multiple times and by that weakening the interconnector 441.

Additionally, the automated placement of the junction box 980 is facilitated.

Compared to known junction boxes, the junction boxes proposed in examples described herein may be particularly flat. This may render the solar cell module usable as roof tiles. Moreover, fewer potting material may be required to fill the junction box after having established the electrical connection saving costs. In addition, the time required for filling the potting material in the junction box may be reduced.

In the example shown in Fig. 9, the bonding is performed by electrical resistance welding using electrodes 991. Electrical resistance welding has the advantage that the interconnector 441 and the conductor 981 are only heated locally. Thus, the risk of damaging or degrading other parts of the solar cell module by heat is reduced. Moreover, the electrodes 991 may be used to press the conductor against the interconnector 441. No further means is required to fix these elements in position during bonding.

However, the bonding may also be performed by soldering. In particular, induction soldering may be used. Compared to welding, soldering may be possible with lower temperatures further reducing the risk of degrading any parts of the solar cell module.

In the examples described with respect to Figs. 6 to 9, the end portion 4412 of the interconnector 441 is a backfolded portion. However, it is also thinkable to use a completely flat interconnector 441, i.e. an interconnector 441 having the collecting portion and the end portion arranged in a single layer. This may reduce the complexity involved with bending the interconnector 441.

Using a backfolded portion may have the advantage that the bonding interface is hidden behind the collecting portion of the interconnector. Thus, colour changes due to welding may not be visible from a front side of the solar cell module improving the esthetical appearance of the solar cell module.

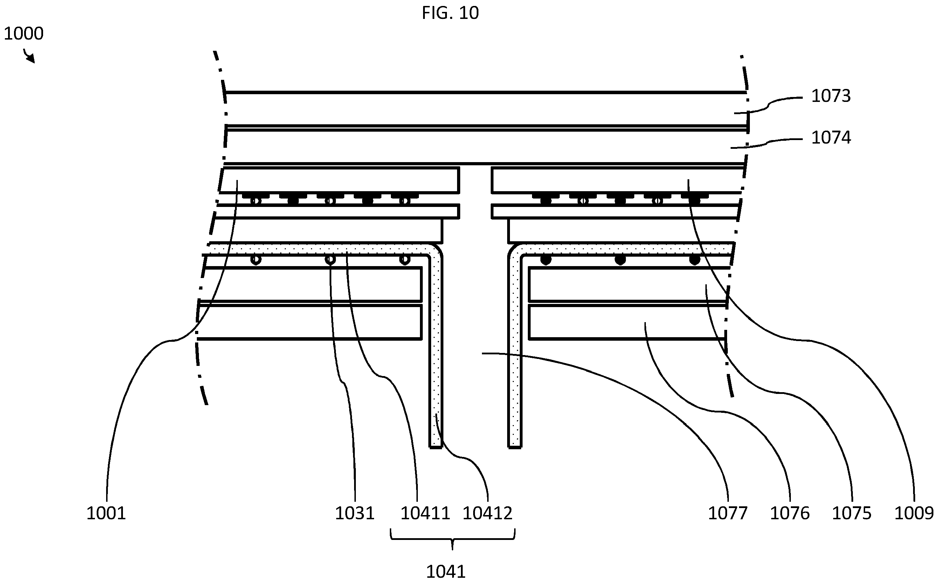

Fig. 10 shows a partly manufactured solar cell module 1000. A front glass 1073 and a front side encapsulation layer 1074 are provided on a front side of solar cells 1001 and 1009, which may correspond to the solar cells 401 and 409 shown in Fig. 4. The interconnector 1041 comprises a collecting portion 10411 electrically connected to the connecting wires 1031 electrically connected to the solar cell 1001 and an angled end portion 10412. The angled end portion 10412 passes through a through hole 1077 provided in the back side encapsulation layer 1075 and the back glass 1076.

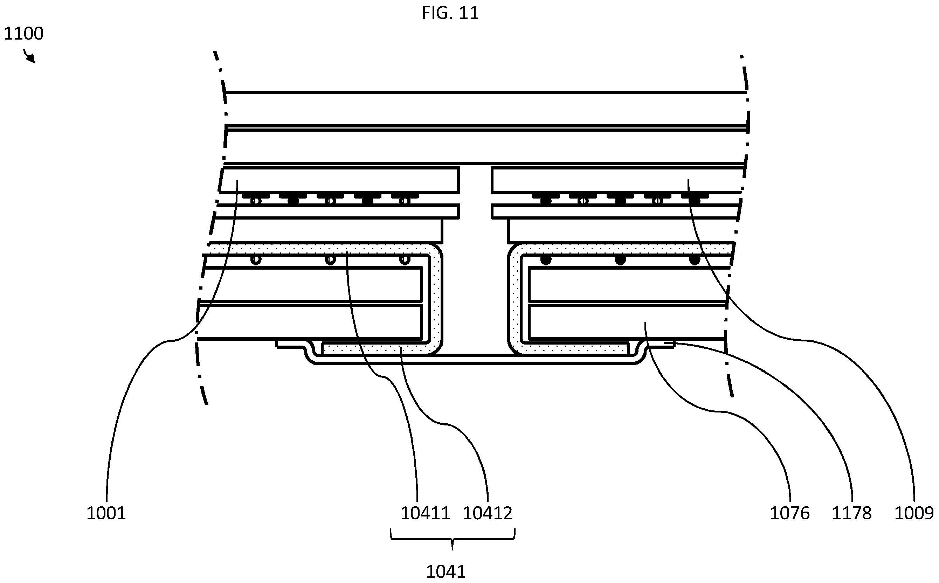

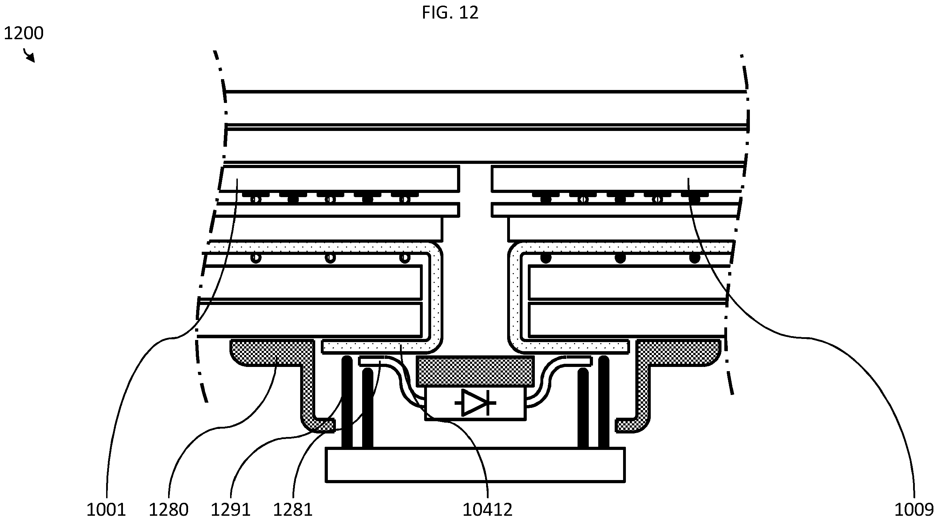

As shown in Fig. 11, the end portion 10412 may be folded back such that the back glass 1076 is arranged between the collecting portion 10411 and the backfolded portion 10412 of the interconnector 1041. An adhesive tape 1178 may be provided covering the backfolded portion 10412 during laminating. This may be useful to avoid that any insulating material covers the part of the surface of the backfolded portion 10412 which is to be electrically connected in further process steps. Although not specifically explained, such an adhesive tape may also be used to cover the backfolded portion 4412 shown in Fig. 8 during laminating. Similar to Fig. 9, Fig. 12 shows the bonding of a conductor 1281 of a junction box 1280 to the backfolded portion 10412 using electrodes 1291 during manufacture of the solar cell module 1200.

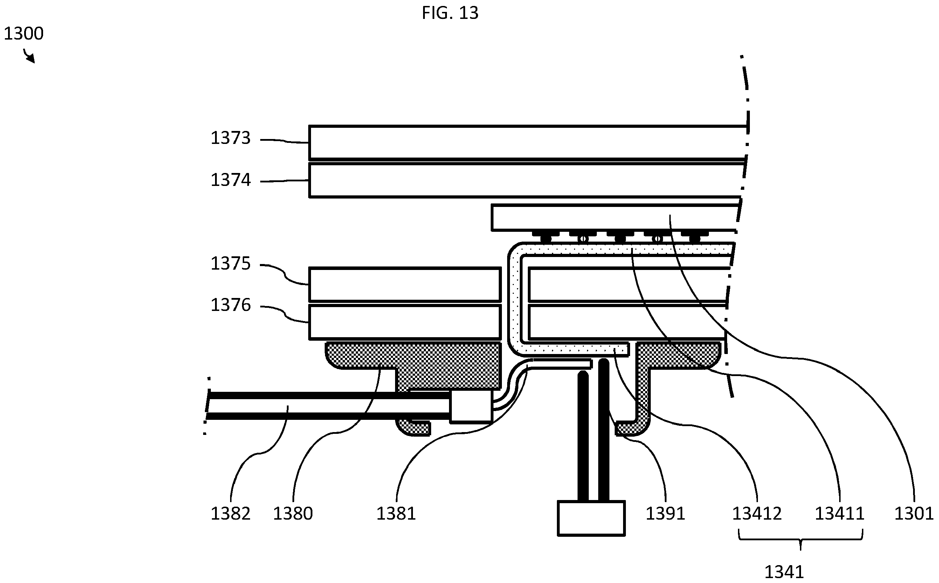

Fig. 13 shows a further solar cell module 1300 with a front glass 1373, a front side encapsulation layer 1374, a back side encapsulation layer 1375 and a back glass 1376. In contrast to the solar cell modules of Fig. 9 and Fig. 12, the collecting portion 13411 is not provided behind the solar cell 1301 but laterally of the solar cell 1301 similarly to the interconnector 141 shown in Fig. 3. Fig. 13 shows an edge of the solar cell module 1300 and electrodes 1391 for contact resistance welding. The junction box 1380 comprises a conductor 1381 which is connected to a terminal. The terminal may be used to connect an electrical cable 1382 to the solar cell module 1300. Thus, the current collected via the collecting portion 13411 of the interconnector 1341 and conducted via the backfolded portion 13412 may flow through the electrical cable 1382. In Fig. 13, the junction box 1380 only comprises a terminal to which the conductor 1381 is connected. However, in other examples the junction box may comprise such a terminal for connecting an electrical cable and, in addition, a bridging element. A conductor of the junction box may then be connected to the terminal and the bridging element.

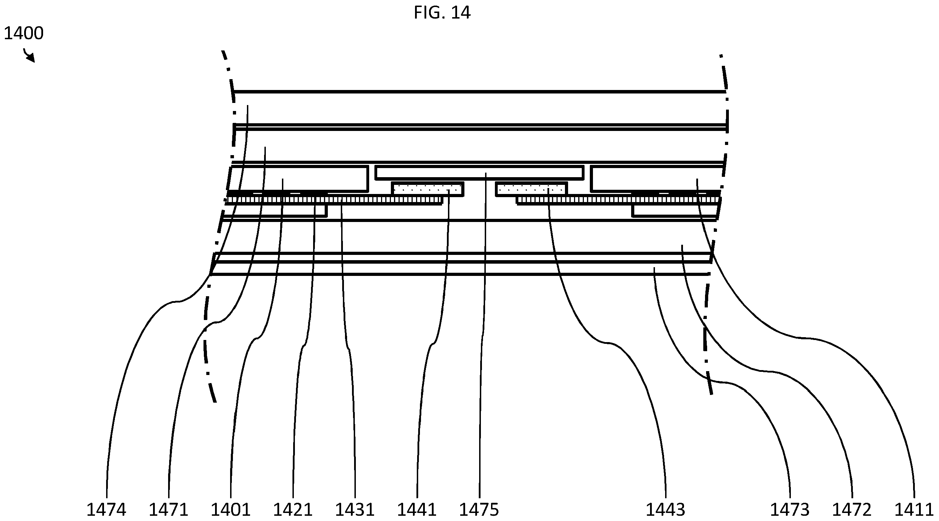

Fig. 14 shows a portion of a solar cell module, in particular of a solar cell module laminate 1400, wherein the interconnectors 1441, 1443 are provided laterally between the solar cells 1401, 1411. The interconnectors 1441, 1443 and the solar cells 1401, 1411 may correspond to the interconnectors 141, 143 and the solar cells 101, 111 illustrated in Figs. 1 to 3.

The solar cells 1401, 1411 and their connections may have to be protected from the environment to avoid degradation and damage. Typically, they are encapsulated in a solar cell module laminate 1400 as shown in Fig. 14. The solar cell 1401 including solar cell contacts 1421 having a first polarity and solar cell contacts having a second polarity, a plurality of parallel connecting wires 1431 having a contacting portion electrically contacting the solar cell contacts 1421 having the first polarity are arranged between a front side encapsulation layer 1471 and a back side encapsulation layer 1472.

A back sheet 1473 is provided at a side of the back side encapsulation layer 1472 opposite to the solar cell 1401. A front glass 1474 may be provided on a side of the front side encapsulation layer 1471 opposite to the solar cell 1401. Typically, essentially only the front glass 1474 of the solar cell module will be visible for users, when the solar cell module is installed at a certain location. A cover strip 1475 may be provided laterally between the solar cells 1401, 1411 and vertically between the interconnectors 1441, 1443 and the front side encapsulation layer 1471. The cover strip 1475 may shield the part between the solar cells 1401, 1411 of the solar cell module for a person looking through the front glass 1474. Hence, the aesthetic appearance of the solar cell module may be improved.

Some end portions of some interconnectors may have to pass through the laminate to allow for electrically connecting the solar cell module to a cable and further to an electrical installation. In some cases, bridging elements are to be provided outside of the laminate, too.

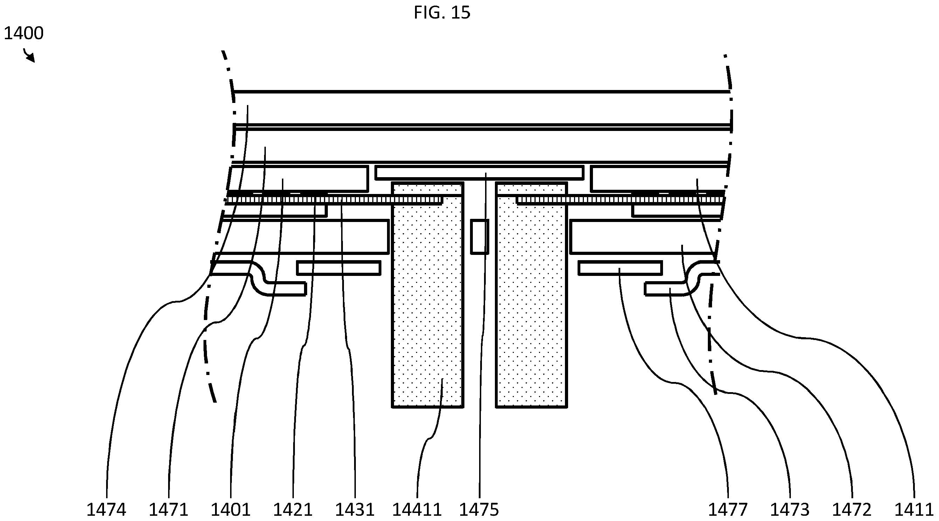

Thus, as indicated in Fig. 15, the end portion 14411 of the interconnector 1441 is passed through an opening in the back side encapsulation layer 1472 and an opening of the back sheet 1473.

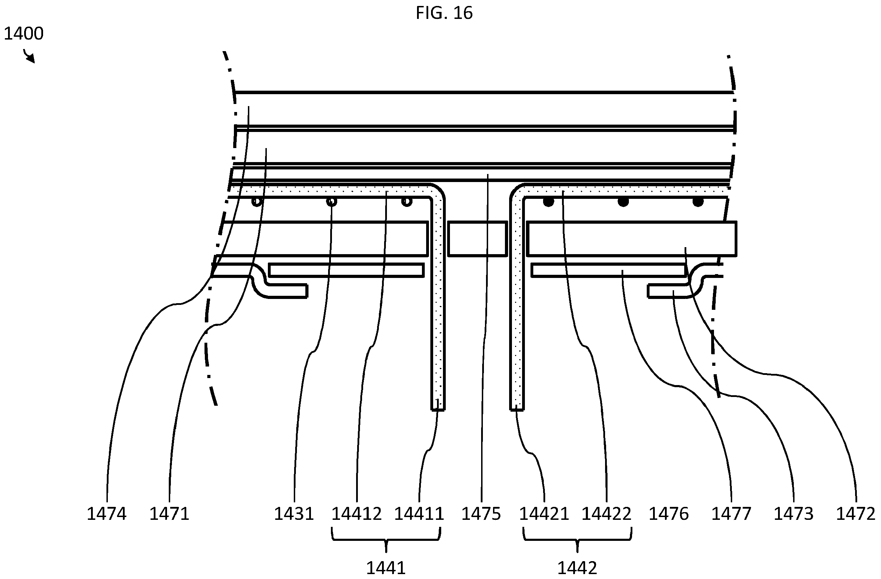

Fig. 16 shows the same portion of the solar cell module laminate 1400 in a view rotated by 90 degree. The end portions 14411, 14421 of the interconnectors 1441, 1442 both pass through the back side encapsulation layer 1472.

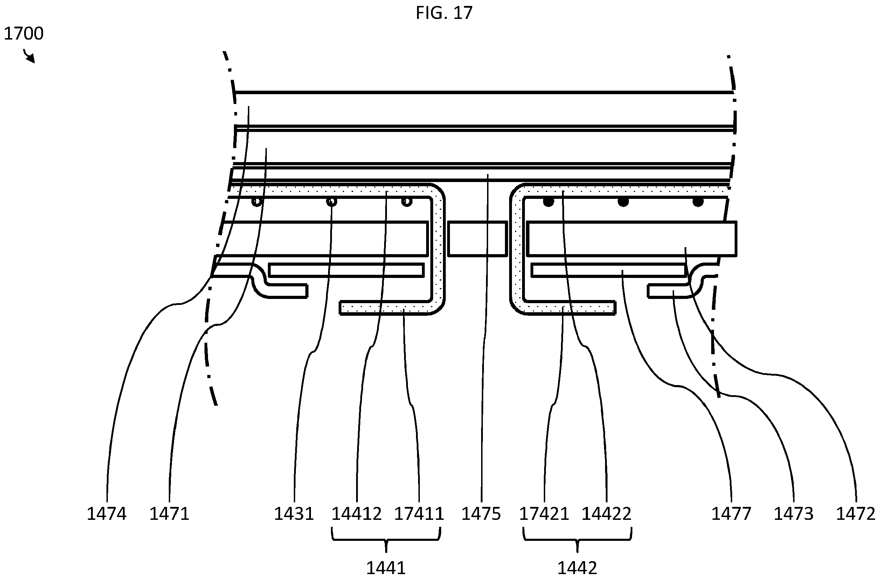

The end portions 14411, 14421 of the interconnectors 1441, 1442 are folded back to obtain back-folded portions 17411, 17421 as shown in Fig. 17.

The back sheet 1473 may comprise a conductive material, for example a metal sheet. The insulating mask 1477 may help to ensure enough non-conductive distance between the edge of the cut of the back sheet 1473 and the interconnector 1441 and/or 1442. The insulating mask 1477 may also help to avoid short circuiting the interconnectors 1441, 1442. The end portions 14411, 14421 are passed through an opening of the insulating mask 1477 which is smaller than the opening of the back sheet 1473.

Laminating may involve applying heat and/or pressure for a well-defined period to the stack. Heat and/or pressure may melt the front side encapsulation layer 1471 and/or the back side encapsulation layer 1472 such that material of the front side encapsulation layer 1471 and/or the back side encapsulation layer 1472 may flow into voids remaining in the stack. Moreover, laminating may help to an adherence of the elements of the stack to each other.

As shown in Fig. 17, the solar cell 1411, a connecting wire 1431 having a contacting portion electrically contacting a solar cell contact of the solar cell 1411 (not shown in Fig. 17), and a collecting portion 14412 of the interconnector 1441 electrically contacting the connecting wire 1431 are arranged between the front side encapsulation layer 1471 and the back side encapsulation layer 1472. The end portion 14411/17411 is passed through an opening of the back side encapsulation layer 1472.

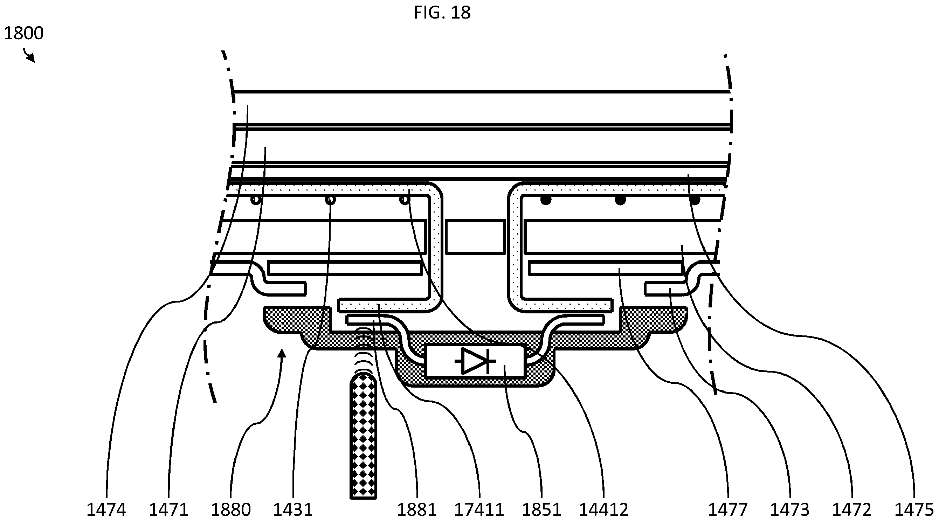

Fig. 18 shows a portion of a solar cell module 1800. A junction box 1880 is provided on the solar cell module laminate 1700 shown in Fig. 17 such that the back side encapsulation layer 1472 is arranged between the front side encapsulation layer 1471 and the junction box 1880. The junction box comprises a housing and a conductor 1881. The conductor 1881 is contactless materially bonded to the end portion 17411 of the interconnector 1441. A bridging element 1851, in particular a bypass diode may be encapsulated in the junction box 1880.

The conductor 1881 maybe partly encapsulated in the housing of the junction box 1880. In some examples, the conductor 1881 may be enclosed by the housing of the junction box 1880 and the solar cell module laminate 1700 after arranging the junction box 1880 on the solar cell module laminate 1700.

The junction box 1880 may be glued and/or taped to the solar cell module laminate. In particular, the junction box 1880 may be glued and/or taped to the solar cell module laminate before bonding the conductor 1881 to the end portion / back-folded portion 17411 of the interconnector.

Contactless materially bonding may comprise at least one of induction soldering, induction welding, laser welding, and/or electron beam welding. These processes may involve transmitting electro-magnetic fields through the housing of the junction box 1880. The conductor 1881 may be elastic. Thus, elastic forces may press the conductor 1881 against the end portion / back-folded portion 17411 after gluing and/or taping the junction box 1880 to the solar cell module laminate 1700 and before performing the materially bonding.

The housing of the junction box 1880 may be lid free. In particular, bridging elements and/or electrical cables for connecting the solar cell module to a power grid may be completely encapsulated in the housing of the junction box 1880. The junction box 1880 may be free of any void which has to be filled with potting material after attaching the junction box 1880 to the solar cell module laminate. Thus, omitting the potting step may reduce the complexity of the manufacturing process. Moreover, omitting the potting material may allow for cost savings.

It may also be possible to contactless materially bond the conductors 1281, 1381 of the junction boxes 1280, 1380 shown in Fig. 12, 13 to the respective interconnectors 1041, 1341. Moreover, it may be possible to replace the junction boxes 1280, 1380 with a junction box similar to junction box 1880 shown in Fig. 18.

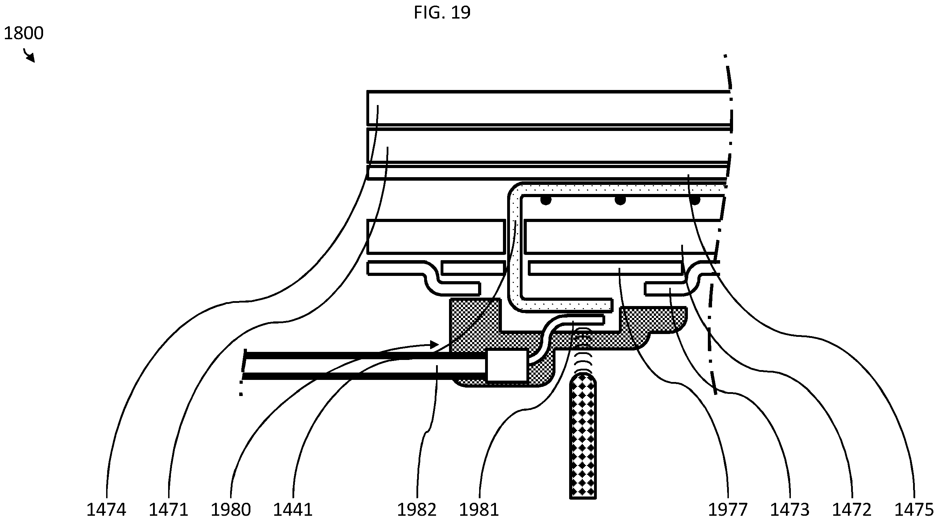

Fig. 19 shows another portion of the solar cell module 1800. The solar cell module 1800 may comprise a further junction box 1980 comprising a conductor 1981 connected to a cable 1982. The element 1977 may correspond to the element 1477 shown in Fig. 18.

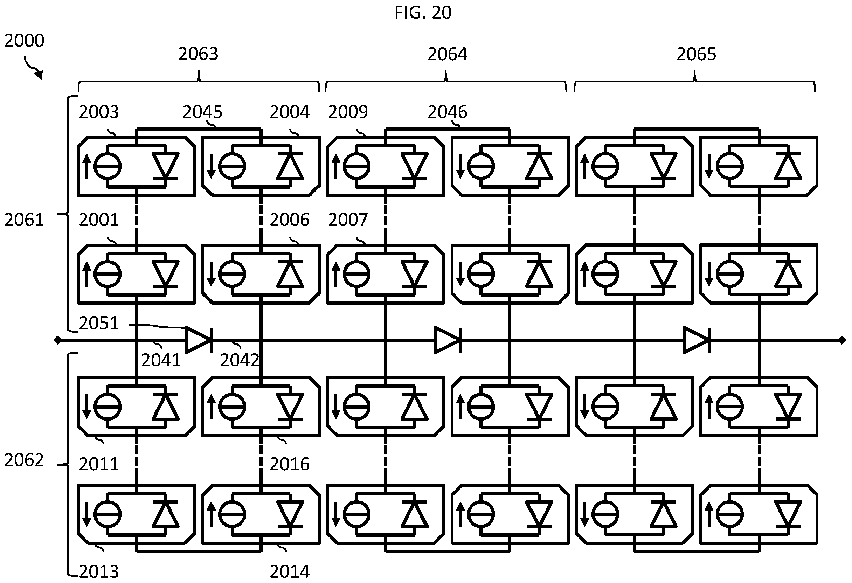

Fig. 20 illustrates a solar cell module 2000. More particularly, Fig. 20 schematically illustrates the electrical circuit of the solar cell module 2000 and the arrangement of the solar cells 2001, ..., 2016, etc. of the solar cell module 2000, when looking on a front side of the solar cell module 2000.

The solar cell module 2000 comprises a first solar cell unit 2061 and a corresponding second solar cell unit 2062. The first solar cell unit 2061 and the second solar cell unit 2062 are electrically connected in parallel. The first solar cell unit 2061 comprises three similar solar cell subunits 2063, 2064, 2065 connected in series. Generally, the first solar cell unit 2061 may also comprise fewer or more subunits connected in series.

The first solar cell subunit 2063 comprises a first solar cell string including the solar cells 2001, ..., 2003 and a second solar cell string including the solar cells 2004, ..., 2006. Each solar cell string may comprise two or more solar cells.

The first solar cell string may be electrically connected in series with the second solar cell string using an interconnector 2045. In particular, the first solar cell string and the second solar cell string may share the same interconnector 2045. A bridging element 2051 may be electrically connected in parallel to the solar cell subunit 2063 and the corresponding solar cell subunit of the second solar cell unit 2062. Further bridging elements may be provided for the further solar cell subunits 2064, 2065, ... of the solar cell unit 2061 and the corresponding solar cell subunits of the solar cell unit 2062. The bridging elements shown in Fig. 20 are diodes. The diodes may also be called bypass diodes. However, different bridging elements, e.g. active switches, may be used alternatively or in addition. The bridging element 2051 may allow for current to pass through the solar cell unit 2061 in case the solar cells 2001, ... 2003, 2004, ..., 2006 of the solar cell subunit 2063 and/or the solar cells 2011, ..., 2013, 2014, ..., 2016 are not irradiated. This may increase efficiency of the solar cell module 2000.

The bridging element 2051 is electrically connected to interconnectors 2041, 2042 of solar cells 2001, 2006.

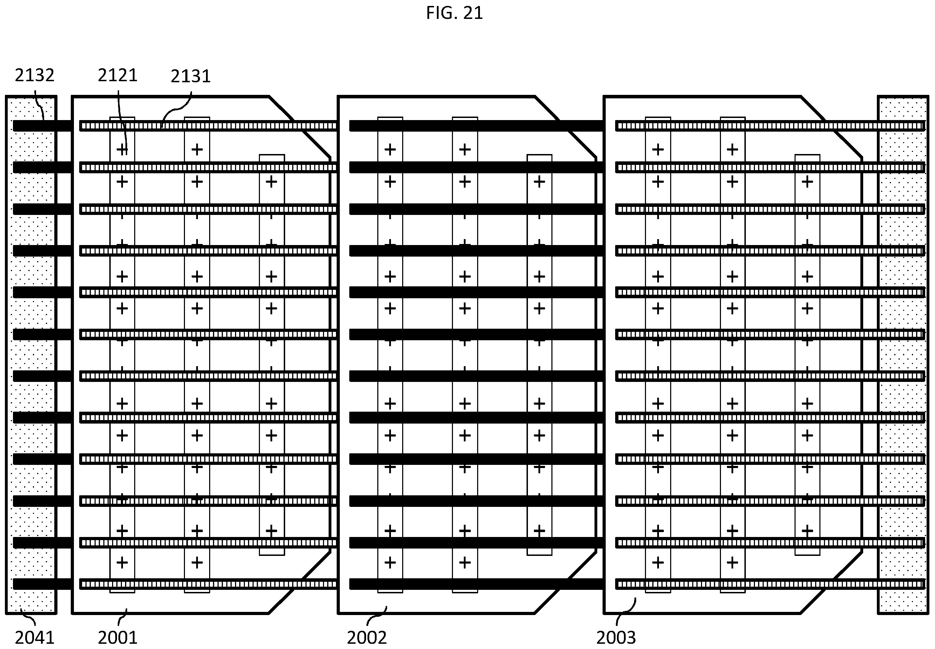

Fig. 21 illustrates the first solar cell string comprising the solar cells 2001, 2002, 2003 of the solar cell module 2000 shown in Fig. 20. The solar cell string is shown from the back side of the solar cell module 2000. The solar cells 2001, 2002, 2003 include solar cell contacts 2121 having a first polarity, e.g. plus or minus, and solar cell contacts having a second polarity, e.g. minus or plus, respectively. The solar cell contacts having the second polarity are provided behind the solar cells 2001, 2002, 2003 shown in Fig. 21.

The solar cell string comprises a plurality of parallel connecting wires 2131 having a contacting portion electrically contacting the solar cell contacts 2121 having the first polarity of the solar cell 2001 and the solar cell contacts having the second polarity of the solar cell 2002.

An interconnector 2041 is provided having a collecting portion crossing a plurality of parallel connecting wires 2132 and electrically contacting a plurality of parallel connecting wires 2132.

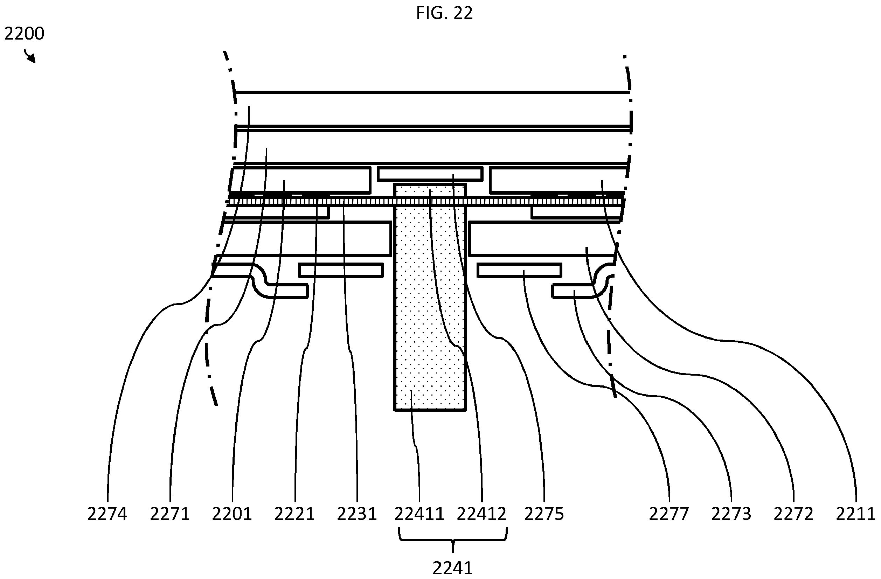

Fig. 22 shows a portion of a solar cell module, in particular of a solar cell module laminate 2200, wherein the interconnector 2241 is provided laterally between the solar cells 2201, 2211. The interconnector 2241 and the solar cells 2201, 2211 may correspond to the interconnector 2041 and the solar cells 2001, 2011 illustrated in Figs. 20 and 21.

The solar cells 2201, 2211 and their connections may have to be protected from the environment to avoid degradation and damage. Typically, they are encapsulated in a solar cell module laminate 2200 as shown in Fig. 22. The solar cell 2201 including solar cell contacts 2221 having a first polarity and solar cell contacts having a second polarity, a plurality of parallel connecting wires 2231 having a contacting portion electrically contacting the solar cell contacts 2221 having the first polarity are arranged between a front side encapsulation layer 2271 and a back side encapsulation layer 2272.

A back sheet 2273 is provided at a side of the back side encapsulation layer 2272 opposite to the solar cell 2201. A front glass 2274 may be provided on a side of the front side encapsulation layer 2271 opposite to the solar cell 2201. Typically, essentially only the front glass 2274 of the solar cell module will be visible for users, when the solar cell module is installed at a certain location. A cover strip 2275 may be provided laterally between the solar cells 2201, 2211 and vertically between the interconnectors 2241, 2242 and the front side encapsulation layer 2271. The cover strip 2275 may shield the part between the solar cells 2201, 2211 of the solar cell module for a person looking through the front glass 2274. Thus, the aesthetic appearance of the solar cell module may be improved. An insulating mask 2277 corresponding to the insulating mask 1477 may be provided, too.

Some end portions of some interconnectors may have to pass through the laminate to allow for electrically connecting the solar cell module to a cable and further to a power grid. In some examples, the bridging elements may also be provided outside of the solar cell module laminate.

Hence, as indicated in Fig. 22, the end portion 22411 of the interconnector 2241 is passed through an opening in the back side encapsulation layer 2272 and an opening of the back sheet 2273.

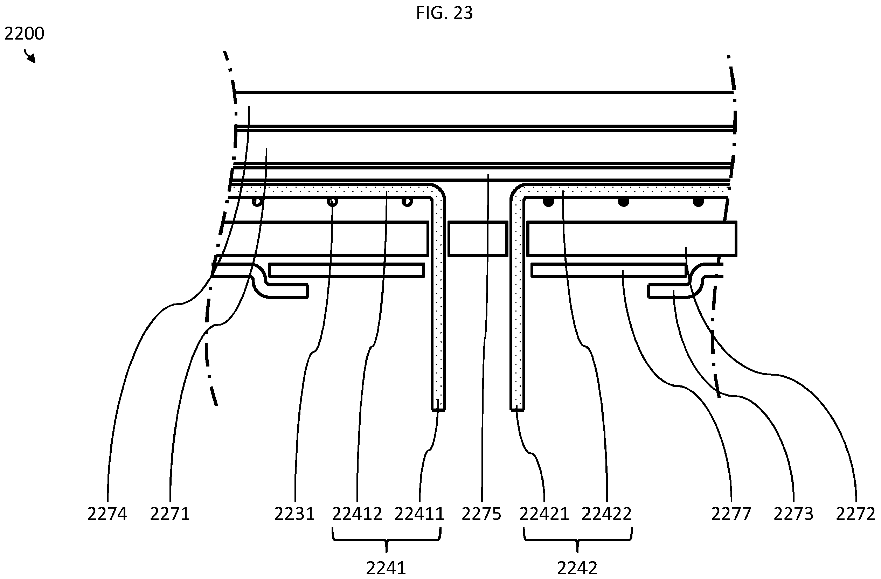

Fig. 23 shows the same portion of the solar cell module laminate 2100 in a view rotated by 90 degree. The end portions 22411, 22421 of both interconnectors 2241, 2242, which may correspond to the interconnectors 2041, 2042 shown in Fig. 20, passes through the back side encapsulation layer 2272.

The end portions 22411, 22421 of both interconnectors 2241, 2242 may later be folded back to obtain back-folded portions.

The examples described herein all have the advantage that bending of the end portion of the interconnector after laminating is avoided. This may severely facilitate the process for attaching the junction box.

In case of a solar cell module including a front glass and a back sheet, end portions of the interconnector may no longer have to be led out of the laminate. Instead, the angled end portions of the interconnector may be folded back before laminating, in particular before arranging the back encapsulation layer and the back sheet behind the solar cells. Slots in the back encapsulation layer and the back sheet may be provided to allow for contacting the backfolded portions. Preferably, the slots are sufficiently large to accommodate the backfolded portions of the interconnectors. This may facilitate keeping the thickness of the laminate the same as without backfolded portions.

The solar cell module described herein may use the design and dimension of the junction boxes. In particular, the same junction boxes may be used for solar cell modules comprising a front glass and a back sheet and solar cell modules comprising a front glass and a back glass.

The proposed method for manufacturing the solar cell modules may have a higher process reliability. Passing angled end portions of interconnectors through openings of junction boxes and/or back sheets may be error prone. Errors may require complex post-processing and/or may reduce the yield of the solar cell modules. The positioning of the junction box with respect to the end portions as proposed herein is less critical.

## Claims

1. Method for manufacturing a solar cell module (1800),
wherein the method comprises
arranging
a solar cell,
a connecting wire (1431) having a contacting portion electrically contacting a solar cell contact of the solar cell, and
a collecting portion of an interconnector crossing the connecting wire (1431) and electrically contacting the connecting wire (1431) between a front side encapsulation layer (1471) and a back side encapsulation layer (1472),
laminating to obtain a solar cell module laminate comprising the front side encapsulation layer (1471), the solar cell, and the back side encapsulation layer (1472),
providing a junction box (1880) on the solar cell module laminate such that the back side encapsulation layer (1772) is arranged between the front side encapsulation layer (1771) and the junction box (1880),
wherein the junction box (1880) comprises a housing and a conductor (1881), and
contactless materially bonding the conductor (1881) to the end portion (17411) of the interconnector.

2. The method according to claim 1,
wherein the conductor (1881) is partly encapsulated in the housing.

3. The method according to claim 2,
wherein the conductor (1881) is enclosed by the housing and the solar cell module laminate after arranging the junction box (1880) on the solar cell module laminate.

4. The method according to any one of claims 1 to 3,
wherein the junction box (1880) is glued and/or taped to the solar cell module laminate, in particular glued and/or taped to the solar cell module laminate before bonding the conductor (1881) to the end portion (17411) of the interconnector.

5. The method according to any one of the claims 1 to 4,
wherein the contactless materially bonding comprises at least one of:
induction soldering,
induction welding,
laser welding, and/or
electron beam welding.

6. The method according to any one of the preceding claims,
wherein the conductor (1881) is elastic.

7. The method according to any one of the preceding claims,
wherein the housing is lid free.

8. The method according to any one of the preceding claims,
wherein the housing comprises a bridging element and the conductor is connected to the bridging element (1851).

9. The method according to any one of the preceding claims,
wherein the method further comprises folding back the end portion (17411) of the interconnector to obtain a back folded portion of the interconnector.

10. The method according to claim 9,
wherein the method further comprises
passing the end portion (17411) through a through hole of a back glass and/or back sheet (1473) of the solar cell module (1806) before folding back the end portion of the interconnector.

11. The method according to claim 9,
wherein the method further comprises
arranging a back sheet (1473) and/or a back glass on a side of the interconnector opposite of the first solar cell such that a slot of the back sheet (1473) and/or back glass accommodates the backfolded portion (17411).

12. Solar cell module (1800) comprising
a solar cell module laminate including
a solar cell,
a connecting wire (1431) having a contacting portion electrically contacting a solar cell contact of the solar cell, and
a collecting portion of an interconnector (14412) crossing the connecting wire and electrically contacting the connecting wire,
wherein the solar cell, the connecting wire (1431) and the collecting portion are arranged between a front side encapsulation layer (1471) and a back side encapsulation layer (1472),
a junction box (1880) on the solar cell module laminate, wherein the back side encapsulation layer (1472) is arranged between the front side encapsulation layer (1471) and the junction box (1880),
wherein the junction box (1880) comprises a housing and a conductor (1881),
wherein the conductor (1881) is materially bonded to an end portion (17411) of the interconnector,
wherein the conductor (1881) is insulated from the ambient by the housing and the solar cell laminate,
wherein the housing is lid-free.

13. Solar cell module according to claim 12,
wherein a contacting interface between the conductor (1881) and the end portion (17411) is arranged in a plane parallel to the solar cell.

14. Solar cell module according to claim 12 or 13,
wherein the end portion (17411) is a backfolded portion.

15. Solar cell module according to any one of claims 11 to 14,
wherein the interconnector passes through a through hole of a back glass and/or back sheet (1472) of the solar cell module (1800), and
wherein the back glass and/or back sheet (1472) is arranged between the collecting portion (14412) and the backfolded portion (17411) of the interconnector.

16. Solar cell module according to any one of claims 11 to 14,
wherein the end portion is accommodated in a slot of a back sheet and/or back glass of the solar cell module.

17. Solar cell module according to any one of claims 11 to 16,
wherein the conductor (1881) is electrically connected to a bridging element (1851), in particular a diode.

18. Solar cell module according to any one of claims 11 to 17,
wherein the conductor (1981) is electrically connected to a cable (1982).
